(19) Europäisches Patentamt
European Patent Office
Office européen des brevets

(11) **EP 3 401 719 A1**

(12) **EUROPEAN PATENT APPLICATION**

(43) Date of publication:
**14.11.2018 Bulletin 2018/46**

(51) Int Cl.:
*G02B 19/00* (2006.01)   *H01L 33/58* (2010.01)
*H01L 33/60* (2010.01)   *F21V 5/00* (2018.01)
*F21V 5/04* (2006.01)   *F21V 7/00* (2006.01)
*G02F 1/13357* (2006.01)   *H01L 33/48* (2010.01)

(21) Application number: **17176547.2**

(22) Date of filing: **19.06.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **08.05.2017  KR 20170057626**

(71) Applicant: **J-TEK. CO
Suwon-si, Kyunggi-do 16648 (KR)**

(72) Inventors:
• **Chung, Hai Woon
Hanam-si, Kyunggi-do (KR)**
• **Yang, Keun Young
Yongin-si, Kyunggi-do (KR)**

(74) Representative: **Nobbe, Matthias
Demski & Nobbe
Patentanwälte
Mülheimer Strasse 210
47057 Duisburg (DE)**

(54) **DIFFUSING LENS AND LIGHT EMITTING DEVICE USING THE SAME**

(57)   A diffusing lens (40) and a light emitting device using the same are provided. The diffusing lens (40) includes an input portion (11; 11') concavely formed on a bottom surface of a lens body (10; 10') and having a first convex portion (12) at a center of the input portion (11; 11'); an output portion (17) having a first output surface (13) concavely formed around a center of a top surface of the lens body (10; 10') and a second output surface (15; 15') convexly formed around the first output surface (13), wherein a second convex portion (14) is formed at a center of the first output surface (13); and a reflection portion (19; 19') formed on the bottom surface of the lens body (10; 10') and located around the input portion (11; 11') to reflect an incident light in the lens body (10; 10'). The first output surface (13) extends from a light axis of the diffusing lens (40) until a predetermined distance from the light axis and is formed into an elliptical shape with two focuses, and the second output surface (15; 15') extends from the predetermined distance to surround the first output surface (13) and is formed into a circular shape with a predetermined radius.

Figure 1

**Description**

1. Field

The present invention relates to a diffusing lens and a light emitting device using the same, and more specifically relates to a diffusing lens capable of uniformly diffusing incident light and a light emitting device using the same.

2. Description of the Related Art

In general, a light emitting diode (LED) is a semiconductor device, and widely used for a light source of an image display device.

A Liquid crystal display (LCD) which is a sort of flat panel displays has no light emitting ability by itself, therefore the LCD displays an image by partially transmitting an external light. To implement the above, a back light unit (BLU) is installed on the rear of the LCD to illuminate with light. This back light unit is demanded to illuminate an entire liquid panel with uniform light.

The LED may be used as the light source of the BLU. In this case, the BLU includes a plurality of LED packages arranged regularly on a substrate, and a diffusion panel diffusing light emitted from the LED packages. The LED package includes a LED chip and a lens concentrating or dispersing the light emitted from the LED chip in accordance with necessities. When the BLU is configured in a direct light emitting type, the lens of the LED package is formed into a diffusing lens.

If the diffusing lens of the LED package is not designed imperfectly, there is a limitation to emit a light with uniform illuminance. The light emitted from the LED has property that concentration of luminous flux is high around the light axis.

Thus, the diffusing lens should be designed to have large light diffusing angle which is an angle between a light and a normal line at a light output surface around the light axis of the diffusing lens in order to emit the light with uniform illuminance. However, as the diffusing angle becomes large, the Fresnel reflection loss is increasing, thereby the illuminance of an emitting surface around the light axis is decreasing. These cause deterioration of color purity at the emitting surface and yellow ring phenomenon in which initially white color of the emitting light is changed into yellow color.

SUMMARY

Some embodiments of the inventive concept provide a diffusion lens and a light emitting device using the same which have structure for suppressing the yellow-ring phenomenon and for emitting uniform diffused light.

In an aspect, the diffusing lens for diffusing incident light includes an input portion concavely formed on a bottom surface of a lens body and having a first convex portion at the center of the input portion; an output portion having a first output surface concavely formed around a center of a top surface of the lens body and a second output surface convexly formed around the first output surface, wherein a second convex portion is formed on a center of the first output surface; and a reflection portion formed on the bottom surface of the lens body and located around the input portion to reflect an incident light in the lens body. The first output surface extends from a light axis until a predetermined distance from the light axis and is formed into elliptical shape with two focuses, and the second output surface extends from the predetermined distance to surround the first output surface and is formed into circular shape with a predetermined radius.

In some embodiments, a lower portion of the second output surface in contact with the reflection portion may be vertically formed with respect to the reflection portion such that an incident light in the lens body is reflected to form uniform light diffusion distribution of light emitted from the output surface.

In another aspect, the diffusing lens for diffusing incident light includes an input portion concavely formed on a bottom surface of a lens body and having a first convex portion at the center of the input portion; an output portion having a first output surface concavely formed around a center of a top surface of the lens body and a second output surface convexly formed around the first output surface, wherein a second convex portion is formed on a center of the first output surface; and a reflection portion formed on the bottom surface of the lens body and located around the input portion to reflect an incident light in the lens body. A plurality of ring shaped patterns with ring shaped concave curved surface is formed concentrically on the reflection portion such that light diffusivity is increased.

In some embodiments, the ring shaped patterns may have same depth and same width.

In other embodiments, width of the ring shaped patterns may increase or decrease with distance from the light axis.

In yet other embodiments, scattering pattern may be formed an entire surface or a sectional surface of the input portion.

In still other embodiments, the scattering pattern has the Haze value 40% or lower.

In yet still other embodiments, the lens body may be formed of a first transparent material with refractive index 1.4 or more and a second transparent material with refractive index 1.4 or more. The second transparent material has different refractive index from the first transparent material, and the second transparent material is mixed at volume ratio 10% or lower such that light transmitting through the lens body is scattered in the lens body.

Embodiments of the inventive concepts provide a light emitting device, the light emitting device includes a base; a light emitting diode mounted on the base to emitting light; and a diffusing lens of at least one of claims 1 through 8. disposed on the base in opposite to the light emitting diode. Light emitted from the light emitting diode is distributed uniformly over a wide range through the diffusing lens.

According to the inventive concept, the diffusing lens has the novel structure of the input portion, the output portion and/or the reflection portion or lens body material to deteriorate the yellow-ring phenomenon or emit uniform diffusion light with wide angle.

Further, the light emitting device with the diffusing lens according to the inventive concept transforms the light emitted from a light emit diode into uniform diffusion light with wide angle. Thus the light emitting device can be used as a back light unit of a display device.

BRIEF DESCRIPTION OF THE DRAWINGS

FIG. 1 is a cross-sectional view illustrating a diffusing lens according to a first embodiment of the inventive concept;
FIGS. 2a and 2b are drawings illustrating a first output surface and a second output surface of a diffusion lens according to a first embodiment of the inventive concept, respectively;
FIG. 3 is a drawing illustrating paths of light through a first and a second output surfaces of a diffusing lens according to a first embodiment of the inventive concept;
FIG. 4 is a cross-sectional view illustrating a diffusing lens according to a second embodiment of the inventive concept;
FIGS. 5a and 5b are simulation results illustrating light distribution through a diffusing lens according to a second embodiment of the inventive concept and a comparative embodiment, respectively;
FIGS. 6a and 6b are schematic views illustrating beam profiles in FIGS. 5a and 5b, respectively;
FIG. 7 is a cross-sectional view illustrating a diffusing lens according to a third embodiment of the inventive concept, and FIG. 8 is a perspective view illustrating a diffusing lens according to a third embodiment of the inventive concept;
FIGS. 9 and 10 are cross-sectional views illustrating modified embodiments of a diffusing lens in FIG. 7, respectively;
FIGS. 11 and 12 are drawings illustrating a diffusing lens according to a fourth embodiment of the inventive concept and a mold for manufacturing the same;
FIG. 13 is a cross-sectional view illustrating a diffusing lens according to a fifth embodiment of the inventive concept;
FIG. 14 is a cross-sectional view illustrating a light emitting device according to a first embodiment of the inventive concept.

DETAILED DESCRIPTION

The inventive concept will become more apparent in view of the attached drawings and accompanying detailed description.

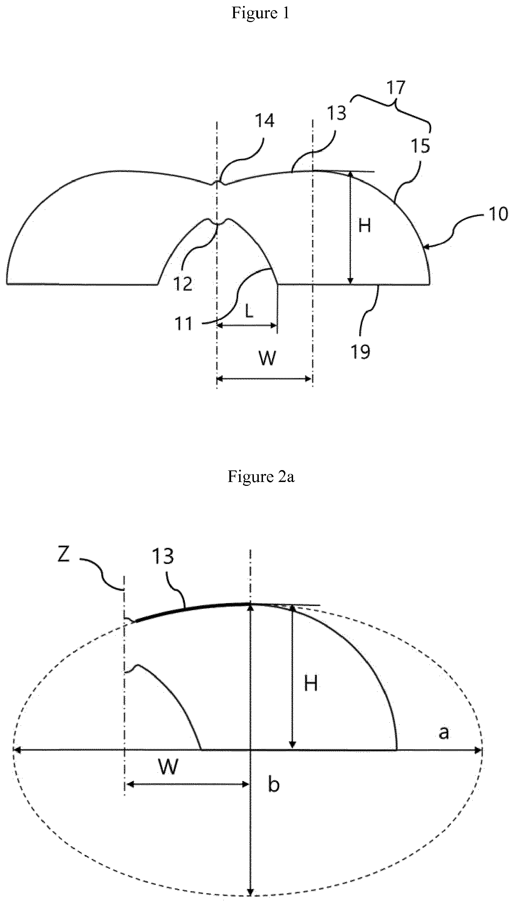

FIG. 1 is a cross-sectional view illustrating a diffusing lens according to a first embodiment of the inventive concept;

Referring to FIG. 1, a diffusing lens according to a first embodiment of the inventive concepts may be formed of a single lens body 10, and may include an input portion 11, an output portion 17 and a reflection portion. The input portion 11 concavely formed on a bottom surface of a lens body 10 and having a first convex portion 12 at the center of the input portion 11. The first convex portion 12 may be formed on a light axis line Z and may get together with a second convex portion 14 to prevent the white spot phenomenon at the center of light emitted at wide angle by the diffusing lens.

The output portion 17 may be composed of a first output surface 13, a second output surface 15 and the second convex portion 14 in accordance with location and shape. The first output surface 13 may be concavely formed around the top surface center of the lens body 10, and the second output surface 15 may be convexly formed around the first output surface 13. The second convex portion 14 may be formed at the center of the first output surface 13. As described above, the second convex portion 14 may be formed on a light axis line Z to prevent the white spot phenomenon at the center of light emitted at wide angle by the diffusing lens.

The reflection portion 19 may be formed on a bottom surface of the lens body 10 and be formed around the input portion 11. The reflection portion 19 may reflect light incident in the lens body 10 such that light loss is minimized and uniform light emission is guided.

Here, a distance W from the center of the lens to an intersection of the first and the second output surfaces 13 and 15 satisfies Equation 1.

[Equation 1]

$$L < W < H$$

L is a distance from the center of the lens to the intersection of the input portion 11 and the reflection portion 19.
H is a height of the lens body.

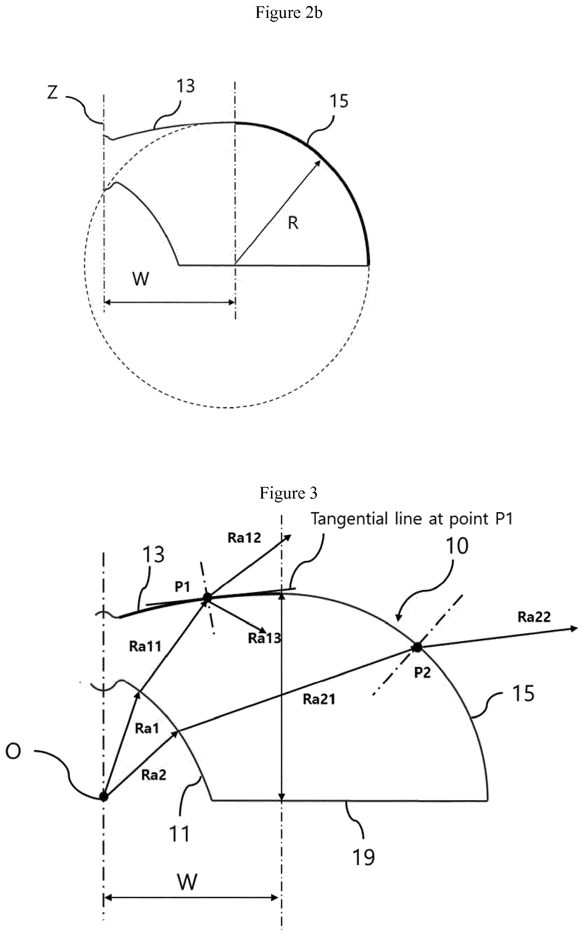

FIGS. 2a and 2b are drawings illustrating a first output surface and a second output surface of a diffusion lens according to a first embodiment of the inventive concept, respectively.

Referring to FIG. 2a, the first output surface 13 extends from the light axis Z to predetermined distance W and may be formed into elliptical shape with two focuses. The first output surface 13 may be formed over predetermined distance W from the vicinity of the second convex portion 14, and have a major axis a and a minor axis b. The miner axis b may be formed in parallel with the light axis Z with leaving a predetermined distance W therebetween. The major axis a may have two times length of the predetermined distance W and two times length of the height of the lens body 10.

The first output surface 13 is formed into elliptical shape at the center of output portion such that light refracted on the first output surface 13 may be diffused in wide angle.

Referring to FIG. 2b, the second output surface 15 may extend from a region where is distance W away from the light axis Z, and may be formed into circular shape with a predetermined radius. That is to say, the center of the circle may be W distance away from the center of the lens and radius of the circular shape may be R. The second output surface 15 is formed into circular shape such that an angle of output light may be controlled.

FIG. 3 is a drawing illustrating paths of light through a first and a second output surfaces of a diffusing lens according to a first embodiment of the inventive concept.

Referring to FIG. 3, light emitted from a point source O such as a light emitting diode is refractively entered into the lens body 10 through the input portion 11. A light Ra1 passing toward the first output surface 13 is passed through the input portion 11 to be refracted light Ra11 and is arrived at a point P1 on the first output surface 13. A portion of light Ra12 is refractively transmitted in accordance with the Snell's law and a remnant light Ra13 is reflected into the lens body 10. Therefore, the reflected light is entered in the reflection portion 19 or a portion of the second output surface 15. The first output surface 13 is formed into elliptical shape such that refractive angle of the light Ra12 may be enlarged. Further, a portion of light Ra13 is reflected in the lens body 10, further reflected on the reflection portion 19 and/or the second output surface 15 and output at different angle such that the uniformity of the output light may be improved.

A light Ra2 passing toward the second output surface 15 is passed through the input portion 11 to be refracted light Ra21 and arrived at a point P2 on the second output surface 15. The second output surface 15 is formed into circular shape and formed around the first output surface 13 such that the light Ra21 may be refractively transmitted the second output surface 15 as indicated in light Ra22.

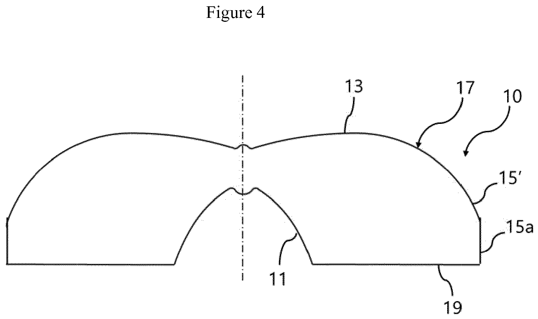

FIG. 4 is a cross-sectional view illustrating a diffusing lens according to another embodiment of the inventive concept.

Referring to FIG. 4, a diffusing lens according to a first embodiment of the inventive concept may be formed into a single lens body 10, include an input portion 11, an output portion 17 and a reflection portion 19. Shape of the second output surface (15') of the output portion 17 may differ from the diffusing lens according to the first embodiment and other components may be substantially the same. A lower portion 15a of the second output surface 15' in contact with the reflection portion 19 may be perpendicularly formed to the reflection portion 19. As the lower portion 15a of the second output surface 15' is formed as the above, the light diffusion distribution of the light emitted through the output portion 17 after reflecting light incident in the lens body 10 can be uniformed.

The vertical height of the lower portion 15a of the second output surface may be formed at 1mm or lower and surface may have the Haze value of 50% through 90% such that the reflected light is scattered. The Haze value represents ratio of diffusive transmitting light in compare with total transmitting light (= diffusive transmitting light + parallel transmitting light). The diffusive transmitting light represents amount of light which is diffusively transmitted at the lower portion 15a of the second output surface.

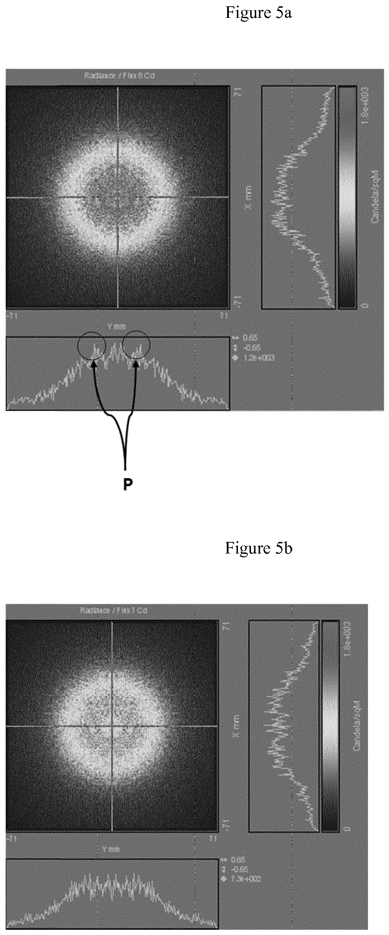

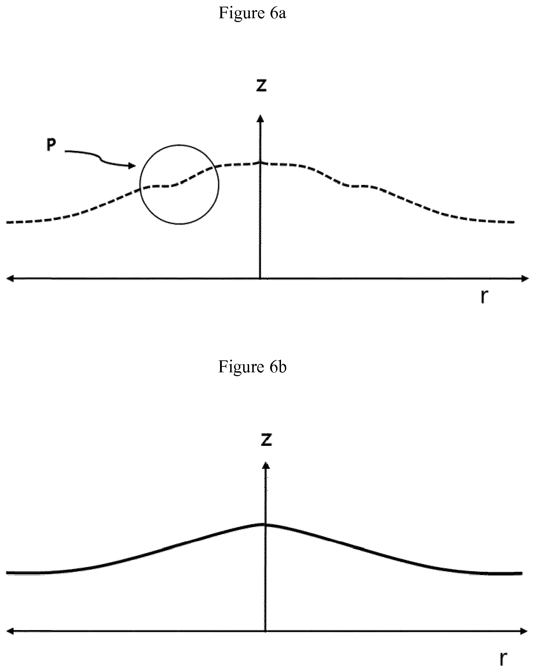

FIGS. 5a and 5b are simulation results illustrating light distribution through a diffusing lens according to another embodiment of the inventive concept and a comparative embodiment, respectively, and FIGS. 6a and 6b are schematic views illustrating beam profiles in FIGS. 5a and 5b, respectively.

Referring to FIGS. 5a and 6a, the diffusing lens according to comparative embodiment was occurred ring shaped pattern P at a portion apart from the light axis Z such that light uniformity is inferior. Here, r is a distance from the center of the lens.

In contrast, referring to FIGS. 5b and 6b, the diffusing lens according to the second embodiment of the inventive concept, in compare with the comparative embodiment, the ring shaped pattern is not shown and the light uniformity is improved.

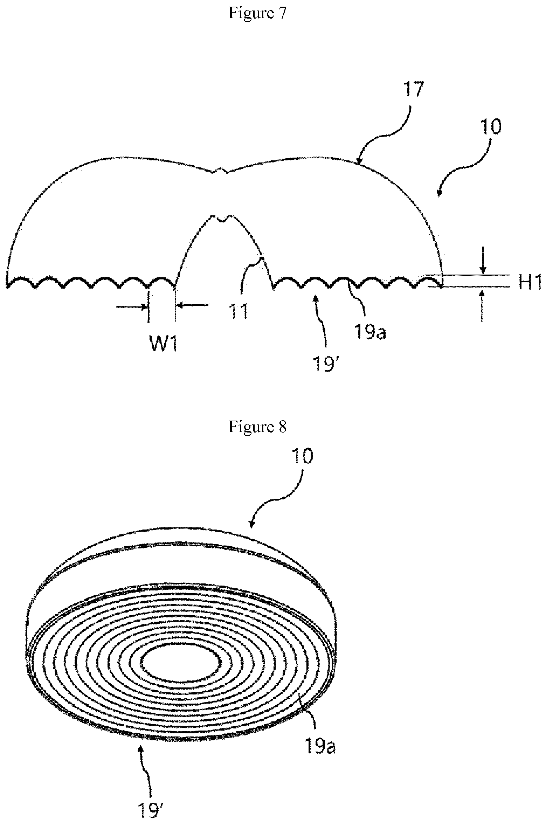

FIG. 7 is a cross-sectional view illustrating a diffusing lens according to yet another embodiment of the inventive concept, and FIG. 8 is a perspective view illustrating a diffusing lens according to a third embodiment of the inventive concept.

Referring to FIGS. 7 and 8, a diffusing lens according to a third embodiment of the inventive concepts may be formed of a single lens body 10, and may include an input portion 11, an output portion 17 and a reflection portion. In contrast to the diffusing lens according to the first and second embodiments of the inventive concept, configure of the reflection portion 19' is different but other elements are substantially the same.

On the diffusing lens 19' according to the embodiment, a plurality of ring shaped patterns 19a with ring shaped concave surface may be concentrically formed. If the ring shaped patterns 19a are formed as the above, the light diffusivity is increased to improve light uniformity.

FIGS. 7 and 8 illustrate a plurality of ring shaped patterns 19a with the concave surfaces of the same depth H1 and the same width W1.

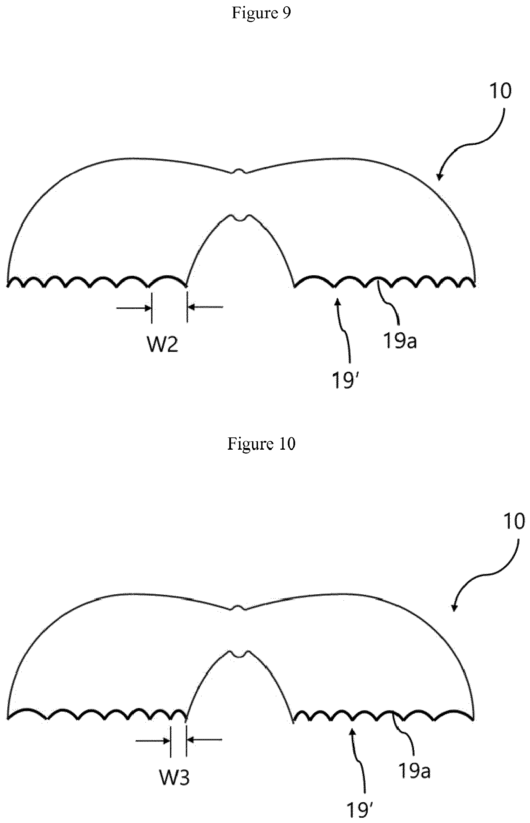

The plurality of ring shaped patterns 19a may be modified as shown in FIGS. 9 and 10. Thus, width of the ring shaped patterns may increase or decrease with distance from the light axis.

Referring to FIG. 9, a ring shaped pattern with widest width W2 is disposed around the center of the lens and the width of the ring shaped patterns decreases with distance from the center of the lens.

Referring to FIG. 10, a ring shaped pattern with most narrow width W3 is disposed around the center of the lens and the width of the ring shaped patterns increases with distance from the center of the lens.

Composing as the above, the diffusing lens with the ring shaped patterns 19a is superior to the diffusing lens with planar surface in light diffusivity when the light passed through the reflective surface 19' of the lens body 10 enter again into the lens body 10. Therefore, it has an advantage that more uniform front bright distribution may be obtained on the diffusion panel (not shown).

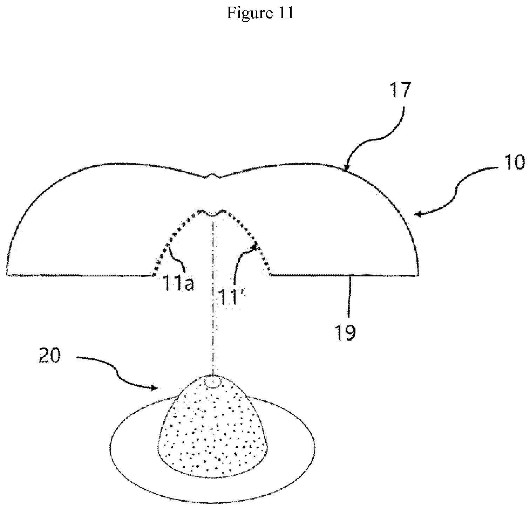

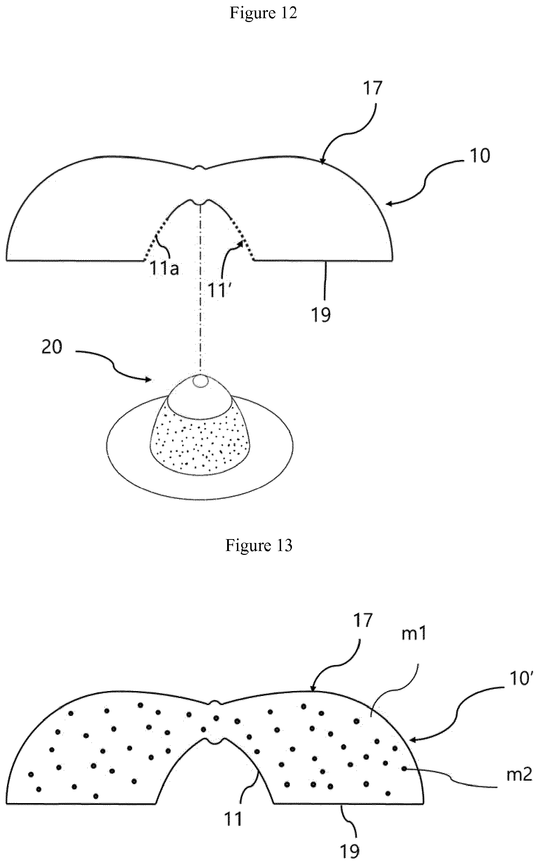

FIGS. 11 and 12 are drawings illustrating a diffusing lens according to a fourth embodiment of the inventive concept and a mold for manufacturing the same.

A diffusing lens according to a fourth embodiment of the inventive concepts may be formed of a single lens body 10, and may include an input portion 11, an output portion 17 and a reflection portion. In contrast to the diffusing lens according to the first through third embodiments of the inventive concept, configure of the reflection portion 11' is different but other elements are substantially the same.

A scattering pattern 11a may be formed on an entire surface of the input portion 11' as shown in FIG. 11 or be formed on a sectional surface of the input portion 11' as shown in FIG. 12. The scattering pattern 11a may be formed by forming a pattern corresponding to the scattering pattern 11a on a mold 20 which is used for manufacturing the diffusing lens.

In this manner, not a mirror surface but the scattering pattern 11a is formed on the input portion 11' such that the light refracted by the curved shape of the input portion 11 is scattered thereby obtaining uniform brightness distribution without ring shape as shown in FIG. 5b.

The scattering pattern may have the Haze value 40% or lower. The Haze value represents ratio of diffusive transmitting light in compare with total transmitting light (= diffusive transmitting light + parallel transmitting light). The diffusive transmitting light represents amount of light which is diffusively transmitted through the input portion of the diffusing lens, and the parallel transmitting light represents amount of light which is directly transmitted through the input portion of the diffusing lens.

FIG. 13 is a cross-sectional view illustrating a diffusing lens according to a fifth embodiment of the inventive concept.

A diffusing lens according to a fifth embodiment of the inventive concepts may be formed of a single lens body 10, and may include an input portion 11, an output portion 17 and a reflection portion. In contrast to the diffusing lens according to the first through fourth embodiments of the inventive concept, there is a feature that material of the lens body 10' is restricted, but other elements are substantially the same.

The lens body 10' may be composed of a first transparent material m1 with refractive index 1.4 or more and a second transparent material m2 with refractive index 1.4 or more. The second transparent material m2 with different refractive index from the first transparent material m1. The second transparent material m2 is mixed at volume ratio 10% or lower such that light transmitting through the lens body is scattered in the lens body. As the diffusing lens is configured in this manner, the light entered through the input portion 11 has scattering effect while passing in the lens body 10', thereby obtaining uniform brightness distribution without ring shape as shown in FIG. 5b.

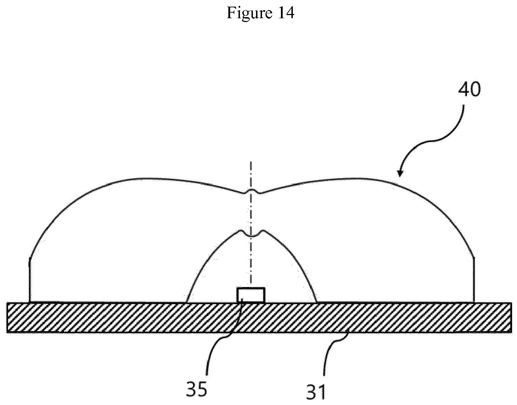

FIG. 14 is a cross-sectional view illustrating a light emitting device according to a first embodiment of the inventive concept.

Referring to FIG. 14, a light emitting device according to an embodiment of the inventive concept may include a base 31 and a light emitting diode 35 disposed on the base 31 to emit light, and a diffusing lens 10.

The diffusing lens 40 may be disposed on the base 31 to opposite to the light emitting diode 35 and diffuse the light emitted from the light emitting diode 35 at wide angle such that uniform light can be emitted. The diffusing lens 40 is substantially the same as described with reference to FIGS. 1 through 13, so detailed description will be left out.

The light emitting device according to an embodiment of the inventive concept includes a diffusing lens with improved structure to emit uniform light without a ring shaped pattern or a yellow ring. Thereby it can be applied as a back light unit of the direct light emitting type liquid crystal display device.

While the inventive concept has been described with reference to example embodiments, it will be apparent to those skilled in the art that various changes and modifications may be made without departing from the spirit and scope of the inventive concept. Thus, the scope of the inventive concept is to be determined by the broadest permissible interpretation of the following claims and their equivalents.

### DESCRIPTION OF SYMBOLS

| | |
|---|---|
| 10, 10': Lens body | 11, 11': Input portion |
| 11a: Scattering pattern | 12: First convex portion |
| 13: First output surface | 14: Second convex portion |
| 15, 15': Second output surface | 17: Output portion |
| 19, 19': Reflection portion | 19a: Ring shaped pattern |
| 20: Mold | 31: Base |
| 37: Light emitting diode | 40: Diffusing lens |

**Claims**

1. A diffusing lens for diffusing incident light comprising:

   an input portion concavely formed on a bottom surface of a lens body and having a first convex portion at the center of the input portion;
   an output portion having a first output surface concavely formed around a center of a top surface of the lens body and a second output surface convexly formed around the first output surface, wherein a second convex portion is formed on a center of the first output surface; and
   a reflection portion formed on the bottom surface of the lens body and located around the input portion to reflect an incident light in the lens body,

   wherein the first output surface extends from a light axis until a predetermined distance from the light axis and is formed into elliptical shape with two focuses, and the second output surface extends from the predetermined distance to surround the first output surface and is formed into circular shape with a predetermined radius.

2. A diffusing lens of claim 1, wherein a lower portion of the second output surface in contact with the reflection portion is vertically formed with respect to the reflection portion such that an incident light in the lens body is reflected to form uniform light diffusion distribution of light emitted from the output surface.

3. A diffusing lens for diffusing incident light comprising:

   an input portion concavely formed on a bottom surface of a lens body and having a first convex portion at the center of the input portion;
   an output portion having a first output surface concavely formed around a center of a top surface of the lens body and a second output surface convexly formed around the first output surface, wherein a second convex portion is formed on a center of the first output surface; and
   a reflection portion formed on the bottom surface of the lens body and located around the input portion to reflect an incident light in the lens body,

   wherein a plurality of ring shaped patterns with ring shaped concave curved surface is formed concentrically on the reflection portion such that light diffusivity is increased.

4. A diffusing lens of claim 3, wherein the ring shaped patterns have same depth and same width.

5. A diffusing lens of claim 3 or 4, wherein width of the ring shaped patterns increases or decreases with distance from the light axis.

**6.** A diffusing lens of claim 1 or 5, wherein scattering pattern is formed an entire surface or a sectional surface of the input portion.

**7.** A diffusing lens of claim 6, wherein the scattering pattern has the Haze value 40% or lower

**8.** A diffusing lens of at least one of claims 1 through 7, wherein the lens body is formed of a first transparent material with refractive index 1.4 or more and a second transparent material with refractive index 1.4 or more, the second transparent material with different refractive index from the first transparent material, and the second transparent material is mixed at volume ratio 10% or lower such that light transmitting through the lens body is scattered in the lens body.

**9.** A light emitting device comprising:

a base;
a light emitting diode mounted on the base to emitting light; and
a diffusing lens of at least one of claims 1 through 8 disposed on the base in opposite to the light emitting diode, wherein light emitted from the light emitting diode is distributed uniformly over wide range through the diffusing lens.

Figure 1

Figure 2a

Figure 2b

Figure 3

Figure 4

Figure 5a

P

Figure 5b

Figure 6a

Figure 6b

Figure 7

Figure 8

Figure 9

W2

19a

19'

Figure 10

W3

19a

19'

EP 3 401 719 A1

Figure 11

15

Figure 12

Figure 13

Figure 14

Europäisches
Patentamt

European
Patent Office

Office européen
des brevets

## EUROPEAN SEARCH REPORT

Application Number

EP 17 17 6547

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | US 2014/328069 A1 (JEONG HAE WOON [KR] ET AL) 6 November 2014 (2014-11-06) * abstract * * figures 6-15 * * paragraph [0039] - paragraph [0044] * * paragraph [0064] - paragraph [0123] * ----- | 1-9 | INV. G02B19/00 H01L33/58 H01L33/60 ADD. F21V5/00 |
| Y | US 2014/119027 A1 (TAKATORI HIROSHI [JP]) 1 May 2014 (2014-05-01) * abstract * * figures 2-10 * * paragraph [0012] - paragraph [0016] * * paragraph [0029] - paragraph [0062] * ----- | 1-9 | F21V5/04 F21V7/00 G02F1/13357 H01L33/48 |
| A | US 2009/207586 A1 (ARAI TAKEO [JP] ET AL) 20 August 2009 (2009-08-20) * abstract * * figures 1-21 * * paragraph [0011] - paragraph [0039] * * paragraph [0069] - paragraph [0118] * ----- | 1-3,6,9 | |
| A | US 8 068 288 B1 (PITOU DAVID S [US]) 29 November 2011 (2011-11-29) * abstract * * figure 11 * * column 2, line 39 - column 3, line 34 * * column 7, line 39 - line 51 * ----- | 1,3,9 | TECHNICAL FIELDS SEARCHED (IPC) F21V G02B G02F H01L |
| A | US 2016/053965 A1 (OH SEUNG HYUN [KR] ET AL) 25 February 2016 (2016-02-25) * the whole document * ----- | 1-9 | |

The present search report has been drawn up for all claims

| Place of search | Date of completion of the search | Examiner |
|---|---|---|
| The Hague | 22 September 2017 | De Kroon, Arnoud |

EPO FORM 1503 03.82 (P04C01)

## ANNEX TO THE EUROPEAN SEARCH REPORT
## ON EUROPEAN PATENT APPLICATION NO.

EP 17 17 6547

This annex lists the patent family members relating to the patent documents cited in the above-mentioned European search report.
The members are as contained in the European Patent Office EDP file on
The European Patent Office is in no way liable for these particulars which are merely given for the purpose of information.

22-09-2017

| Patent document cited in search report | Publication date | Patent family member(s) | Publication date |
|---|---|---|---|
| US 2014328069 A1 | 06-11-2014 | CN 104132304 A<br>JP 5735669 B2<br>JP 2014220230 A<br>KR 101301206 B1<br>TW 201443368 A<br>US 2014328069 A1 | 05-11-2014<br>17-06-2015<br>20-11-2014<br>29-08-2013<br>16-11-2014<br>06-11-2014 |
| US 2014119027 A1 | 01-05-2014 | CN 103775968 A<br>JP 5957364 B2<br>JP 2014086343 A<br>US 2014119027 A1 | 07-05-2014<br>27-07-2016<br>12-05-2014<br>01-05-2014 |
| US 2009207586 A1 | 20-08-2009 | JP 4479805 B2<br>JP 2009192915 A<br>US 2009207586 A1<br>US 2014104815 A1 | 09-06-2010<br>27-08-2009<br>20-08-2009<br>17-04-2014 |
| US 8068288 B1 | 29-11-2011 | NONE | |
| US 2016053965 A1 | 25-02-2016 | KR 101532985 B1<br>KR 101545658 B1<br>KR 101572495 B1<br>US 2016053965 A1<br>US 2017084806 A1 | 02-07-2015<br>20-08-2015<br>02-12-2015<br>25-02-2016<br>23-03-2017 |

EPO FORM P0459

For more details about this annex : see Official Journal of the European Patent Office, No. 12/82